# EUROPEAN PATENT APPLICATION

(11) **EP 2 959 958 A1**
(43) Date of publication of application: **30.12.2015**
(21) Application number: 14290190.9
(22) Date of filing: 25.06.2014
(51) Int. Cl.: B01D 53/26, E21B 47/01, H05K 5/02, H05K 7/00

(54) **Temperature-activated desiccant box for protection of components in a downhole assembly**

(71) Applicant: Services Petroliers Schlumberger, 75007 Paris (FR); Schlumberger Holdings Limited, Road Town, Tortola 1110 (VG); Schlumberger Technology B.V., 2514 JG The Hague (NL)
(72) Inventor: Pauchet, Frederic, 92140 Clamart (FR); Rubio, Vianney, 92140 Clamart (FR); Roumilly, Nicolas, 92140 Clamart (FR); Bourens, Vincent, 92140 Clamart (FR)
(74) Representative: Leonori, Céline

(57) **Abstract**

The disclosure is about a desiccant box comprising at least one wall defining an inside compartment containing a desiccant material. The box is designed so that :
- at a first temperature value, the inside compartment is a substantially vapor tight closed compartment,
- at a second temperature value superior to the first temperature value, at least a portion of the box is permeable to vapor so that vapor can penetrate into the inside compartment.

## Description

### Background of the Disclosure:

During the operating of a well, a lot of tools are operating in downhole environments, under harsh conditions such as high pressure, high temperature, shocks and vibrations. These tools comprise a sealed atmospheric pressure air or gas housing which is intended to be operated in well fluid downhole environment and in which are packaged electronics boards, harnesses and connectors that allow power, sensoring and communication management.

Atmospheric pressure air or gas inside the sealed housing can have residual humidity, and some moisture can also be released from chemical components at high temperature. Electronics boards, harnesses and connectors reliability are impacted by corrosion effects due to the combination of residual humidity and the high temperature, so a desiccant is often added inside the sealed housing to absorb the humidity and mitigate corrosion effects.

As the volume of desiccant used for absorbing humidity inside the sealed housing affects the total volume of the housing and of the tool, the quantity of desiccant stored in the housing remains may be as low as possible.

### Summary of the disclosure :

The present disclosure introduces a desiccant box comprising walls defining an inside compartment containing a desiccant material. At a first temperature value, the inside compartment is vapor-tight closed compartment, whereas at a second temperature value superior to the first temperature value, the box is permeable to vapor so that the vapor can penetrate into the inside compartment.

The present disclosure also introduces a downhole assembly intended to be lowered into a borehole. This assembly comprises a sealed housing. Electrical components and a desiccant box according to the present disclosure are also stored inside of the housing. Therefore, at a first temperature value, the desiccant box is not permeable to vapor and so the water vapor contained inside of the housing does not reach the desiccant. However, at a second temperature value, corresponding to a temperature at which the tool is supposed to be operating downhole, the vapor reaches the inside compartment and the desiccant is able to absorb the vapor.

In fact, when the desiccant box according to the disclosure is installed in the downhole assembly, the desiccant material is in contact with the atmosphere and thus active when high temperature is combined with humidity and may therefore damage the electrical components.

As the absorption capacity of the desiccant directly depends on the volume of desiccant, activating the desiccant when downhole may decrease the volume of desiccant in the housing. It may especially be useful concerning tools that are likely to remain stored a long time next to the well before being sent downhole, such as logging while drilling (LWD) or measurement while drilling (MWD) tools. It however applies to all types of tools that may be sent downhole such as the ones conveyed thanks to wireline, slickline or coiled tubing, no matter how they are used.

Additional aspects of the present disclosure are set forth in the description that follows, and/or may be learned by a person having ordinary skill in the art by reading the materials herein and/or practicing the principles described herein. At least some aspects of the present disclosure may be achieved via means recited in the attached claims.

### Description of the drawings :

Fig.1 is an exploded view of a portion of a desiccant box according to one or several aspects of the present disclosure
Fig. 2 is a perspective view of a portion of the desiccant box of figure 1 in a closed state.
Fig.3 is a schematic view of another desiccant box according to one or several aspects of the present disclosure.
Fig.4A and 4B are schematic views of another desiccant box according to one or several aspects of the present disclosure, respectively at a first and at a second temperature value.
Fig. 5 is a schematic view of a downhole assembly according to one or several aspects of the present disclosure, when this assembly is lowered into a borehole

### Detailed description:

It is to be understood that the following disclosure provides many different embodiments, or examples, for implementing different features of various embodiments. Specific examples of components and arrangements are described below to simplify the present disclosure. These are, of course, merely examples and are not intended to be limiting.

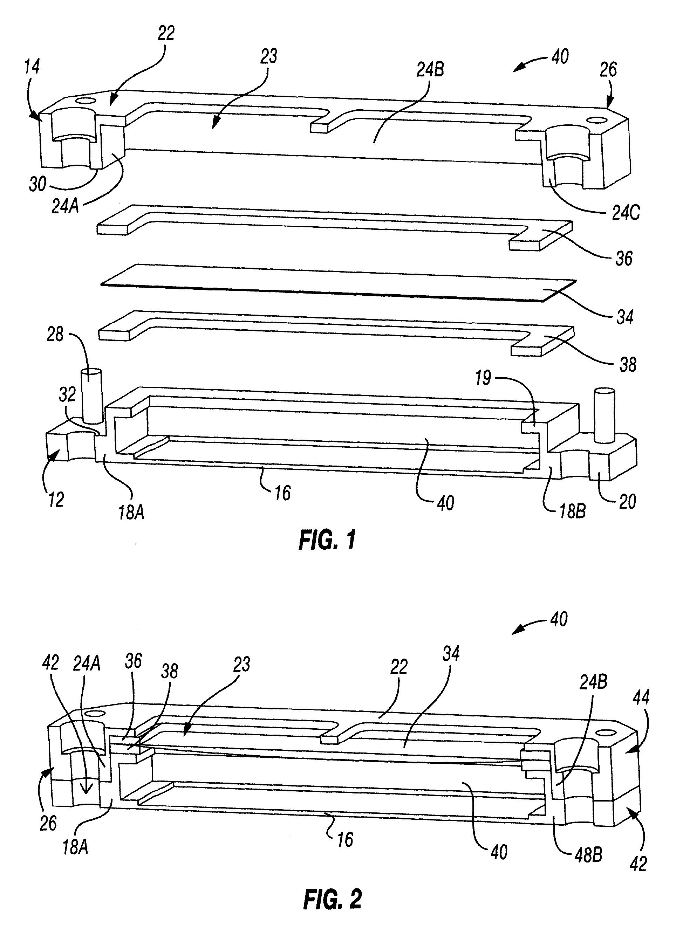

Fig. 1 and 2 are views of a desiccant box 10 according to one or several aspects of the disclosure. As it can be seen from these views, the desiccant box 10 comprises two rigid parts 12 and 14 forming respectively a lower and an upper carrier 12, 14 of the box.

The lower carrier 12 comprises a lower wall 16, four lateral wall 18A-18B (only two of them visible) essentially perpendicular to the lower wall, and a first positioning structure 20 extending outside of the lateral walls. A peripheral rim 19 extends at the upper end of the lateral walls 18A-18B towards the center of the box, parallel to the lower wall.

The upper carrier 14 comprises an upper wall 22, four lateral walls 24A-24C (only three of them visible) essentially perpendicular to the upper wall and a second positioning structure 26 extending outside of the lateral walls. The upper wall 22 presents an opening 23 extending on its central part, on most of its surface.

The upper carrier 14 is intended to be precisely positioned upon the lower carrier thanks to the positioning structures 20, 26. A positioning finger 28 of the first positioning structure of the lower carrier 12 is cooperating with a matching hole (not visible) of the positioning structure the upper carrier for that purpose.

As can be seen on figure 2, once the lower and upper carrier 12, 14 are positioned relative to each other, the lateral walls 24A-24C of the upper carrier extend along the lower walls 18A, 18B of the lower carrier 12, outside these walls. A lower end 30 of the lateral walls 24A-24C of the upper carrier 14 abuts against a projection 32 of the lateral walls 18A-18C of the lower carrier. The lower and upper wall are essentially parallel to each other.

Between the peripheral rim 19 of the lower carrier and the upper wall 22 of the upper carrier, a non-porous thermoplastic film 34 is set with interposition of two peripheral sealing elements 36, 38. The peripheral sealing elements 36, 38 are identical and are dimensioned so as to extend along the rim 19. The thermoplastic film 34 is dimensioned to cover the central opening 23 of the upper wall 22 of the upper carrier 14. Between the rim 19 and the upper wall 22, a first sealing element 36, the thermoplastic film 34 and a second sealing element 38 are superposed.

The thermoplastic film is made of a PEEK (polyétherétherkétone) for instance. It can be made of a great number of other thermoplastic material, such as PEK (polyetherketone), PES (polyethersulfone), PSU (polysulfone), PPSU (polyphenylsulfone), PPF (polypropylene fumarate), PFA (polyfluoroalkoxy).

The lower wall 16, lateral walls 18A, 18C of the lower carrier 12, upper wall 22 of the upper carrier 14 and thermoplastic film 34.define then a closed inside compartment 40 in which a desiccant is stored.

The desiccant can be any type of desiccant, such as silica gel, calcium chloride or sulfate, sodium, potassium carbonate and the like.

The box is closed by inserting through screws and rivets into corresponding holes 42 (two being visible on the figures) of the box. The holes 42 are formed partly in the upper carrier and partly in the lower carrier.

The sole interface between the different parts defining the inside compartment is situated between the rim 19 of the lower carrier and the upper wall 22 of the upper carrier. Thanks to the sealing elements 36, 38 and the through screw compressing these sealing elements, no air or gas coming from outside of the box can go into the closed compartment 40 through the interface between the upper carrier, lower carrier and thermoplastic film.

Thus, as the water vapor permeability of the non-porous thermoplastic material varies with temperature, the thermoplastic film is vapor-tight at a first temperature value. The first temperature value is inferior to 50°C and corresponding generally to ambient temperature. At this first temperature value, the box is then also vapor-tight, and the desiccant material is not in contact with gas situated outside the box and does not absorb any water.

However, as the temperature increases the vapor permeability of thermoplastic film increases, especially at a temperature above the glass transition temperature. When the temperature reaches a second temperature value, which is set around 150°C when the thermoplastic film is made of PEEK, the film and then the box are permeable to vapor. It means that vapor surrounding the box passes through the film and that the desiccant is able to absorb it.

When the tool is not in operation and for instance stored next to the well, the desiccant is not active though it is active when the tool is sent downhole as the temperature increases. The volume of desiccant used in the housing is kept low as there is no need to store in the housing additional desiccant in case the tool is not operating right after its assembly. The vapor tightness of the box can be restored without any external action when the temperature decreases again.

The box is therefore a passive temperature activated device. The one of ordinary skill will choose the material of the thermoplastic film in function of the target second temperature value.

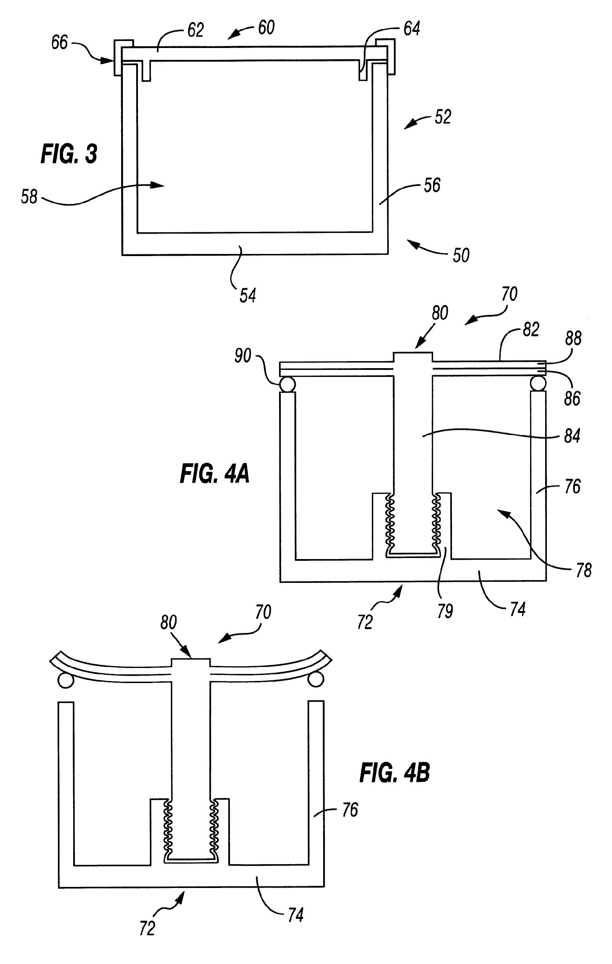

Fig.3 is a schematic view of a desiccant box 50 according to another embodiment of the disclosure.

This desiccant box 50 comprises a lower carrier 52 comprising a lower wall 54 and a circular lateral wall 56, defining an inside compartment 58 open at its upper end. The desiccant material is intended to be stored in this compartment 58.

It also comprises an upper carrier 60 forming a lid for the lower carrier 52 and closing the inside compartment 58. The lid 60 comprises a wall 62 forming an upper wall of the box and a peripheral projection 64 perpendicular to the wall 62 and intended to extend along the lateral wall 56 of the lower carrier 52, inside of this wall, in order to position the lid 60 on the lower carrier 52. The lateral end of the upper wall 62 is then flush with the outside face of the lateral wall 56.

A wax strip 66 surrounds the upper end of the desiccant box so that it covers the interface between the lower and upper carrier all around the box. This wax strip 66 is for instance created by pouring melted wax on the upper part of the box. The melted wax then solidifies, forming the strip. This wax strip seals the interface between the lower carrier 52 and the lid 60, ensuring the water vapor tightness of the inside compartment.

Therefore, at a first temperature value corresponding to ambient temperature, especially inferior to 45°C, the desiccant box is vapor tight and the desiccant does not absorb water from the air or gas surrounding the box. However, at a second temperature value superior to the first temperature value, the wax melts and therefore does not cover anymore the interface between the lid 60 and the lower carrier 52, creating a passage between the inside compartment 58 and outside of the box, through which the air surrounding the box can reach the inside compartment.

The desiccant is used once the temperature reachs a value that is higher than a targeted value. The kind of wax used can be chosen in function of the targeted value of the second temperature value.

Fig. 4A and 4B are schematic views of a desiccant box 70 according to another embodiment of the disclosure. Fig. 4A represents the desiccant box 70 at the first temperature value while fig.4B represents the same box at the second temperature value.

The desiccant box 70 comprises, like box 50, a lower carrier 72 comprising a lower wall 74 and a circular lateral wall 76, defining an inside compartment 78 open at its upper end. The desiccant material is intended to be stored in this compartment 78. The lower carrier also comprises a central cylinder wall 79 attached to the lower wall 74 and extending perpendicular to the lower wall at the center of the compartment towards the upper end of the lateral wall. The cylinder wall defines an inner space and the inside face of this wall is threaded.

The box 70 also comprises an upper carrier 80 comprising an upper wall 82 and a central pole 84 attached to the upper wall and extending essentially perpendicular to the upper wall. The upper wall is located in the vicinity of a first longitudinal end of the pole 84. The central pole 84 is of greater height than the lateral wall 76 of the box 50 and is also threaded at its longitudinal end opposite to the first longitudinal end. This pole 84 is dimensioned so that its threaded part is able to cooperate with the threaded inside face of the cylinder wall of the lower carrier.

The upper wall 82 is made of a bimetallic element comprising two layers 86, 88 of different metallic material (for instance copper and aluminium, or invar and nickel) on top of each other. A sealing element 90 is disposed on the lower face of the upper wall so as to be able to abut on the upper end of the lateral wall 76 of the lower carrier 72 when the pole is placed inside the cylinder wall. The box is then able to be sealed and in particular vapor tight when the pole is set into the cylinder wall so that the sealing element 90 is compressed against the upper end of the lateral wall 76.

As it is known from the one of ordinary skill, the shape of the bimetallic element can however vary in function of the temperature, Indeed, one of the layers of the bimetallic element dilates more than the other due to the difference of the thermal dilatation coefficient of these layers which leads to a deformation of the bimetallic element as it can be seen on figure 4B. Here, the material in the bottom layer has a thermal dilatation coefficient which is higher than the one of the top layer material.

Thus, even if at a first temperature value the inside compartment is sealed and no vapor from the outside of the box can reach the inside compartment, when the temperature reaches a preset value, the bimetallic element curves so that the lateral end of the upper wall 82 goes away from the lateral wall. The sealing element 90 is therefore no more in close contact with the lateral wall 76 and there is a passage between the lateral wall 76 and upper wall 82 so that the air or gas can penetrate in the inside compartment and desiccant can finally absorb the humidity in the air surrounding the box, at a second temperature value. The vapor tightness of the box is restored without any external action when the temperature decreases again.

The box is also a passive temperature activated device. It is easy to design the upper wall so that the second temperature value corresponds to a targeted value, by changing the depth of each layer and/or the nature of each material.

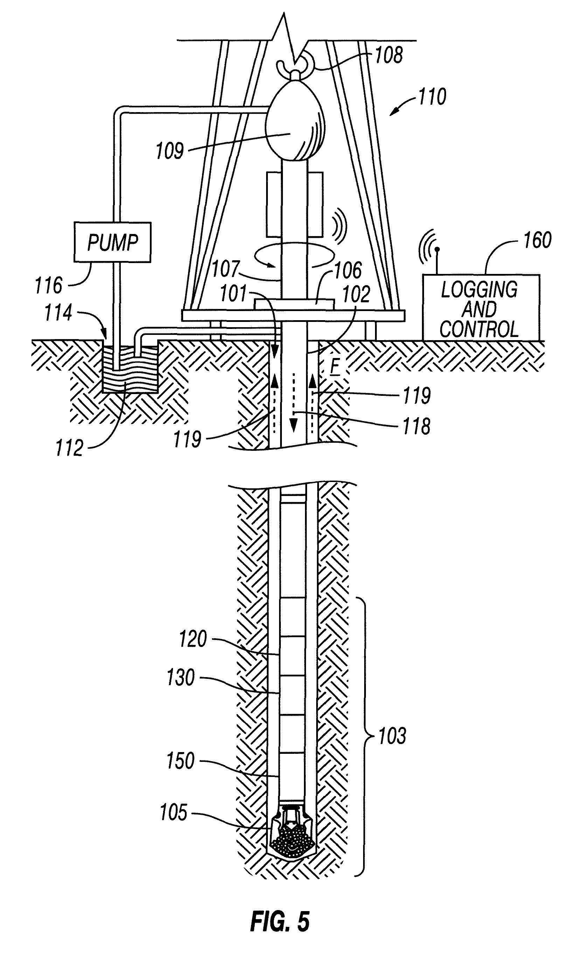

FIG. 5 is a schematic view of an example wellsite system that can be employed onshore and/or offshore, where the wellbore 101 may have been formed in the one or more subsurface formations F by rotary and/or directional drilling. As depicted in FIG. 5, a conveyance means 102 suspended within the wellbore 101 may comprise or be connected to a bottom hole assembly (BHA) 100, which may have a drill bit 105 at its lower end. The conveyance means 102 may comprise drill pipe, wired drill pipe (WDP), tough logging conditions (TLC) pipe, coiled tubing, and/or other means of conveying the BHA 103 within the wellbore 101.

The surface system at the wellsite may comprise a platform and derrick assembly 110 positioned over the wellbore 101. The assembly 110 may include a rotary table 106, a kelly 107, a hook 108, and/or a rotary swivel 109. The conveyance means 102 may be rotated by the rotary table 106, energized by means not shown, which may engage the kelly 107 at the upper end of the conveyance means 102. The conveyance means 102 may be suspended from the hook 108, which may be attached to a traveling block (not shown), and permits rotation of the drillstring 102 through the kelly 107 and the rotary swivel 109. A top drive system may also or instead be utilized.

The surface system may also include drilling fluid 112, which is commonly referred to in the industry as mud, stored in a pit 114 formed at the well site. A pump 116 may deliver the drilling fluid 112 to the interior of the conveyance means 102 via a port (not shown) in the swivel 109, causing the drilling fluid to flow downwardly through the conveyance means 102 as indicated by the directional arrow 118. The drilling fluid 112 may exit the conveyance means 102 via ports in the drill bit 105, and then circulate upwardly through the annulus region between the outside of the conveyance means 102 and the wall of the wellbore, as indicated by the directional arrows 119. The drilling fluid 112 may be used to lubricate the drill bit 105, carry formation cuttings up to the surface as it is returned to the pit 114 for recirculation, and/or create a mudcake layer (not shown) on the walls of the wellbore 101. Although not pictured, one or more other circulation implementations are also within the scope of the present disclosure, such as a reverse circulation implementation in which the drilling fluid 112 is pumped down the annulus region (*i.e.,* opposite to the directional arrows 119) to return to the surface within the interior of the conveyance means 102 (*i.e*., opposite to the directional arrow 118).

The BHA 103 may include various numbers and/or types of downhole tools, schematically depicted in FIG. 5 as tools 120, 130, and 150. Examples of such downhole tools include an acoustic tool, a density tool, a directional drilling tool, a DFA tool, a drilling tool, an EM tool, a fishing tool, a formation evaluation tool, a gamma ray tool, a gravity tool, an intervention tool, a logging while drilling (LWD) tool, a magnetic resonance tool, a measurement while drilling (MWD) tool, a monitoring tool, a mud logging tool, a neutron tool, a nuclear tool, a perforating tool, a photoelectric factor tool, a porosity tool, a reservoir characterization tool, a reservoir fluid sampling tool, a reservoir pressure tool, a reservoir solid sampling tool, a resistivity tool, a seismic tool, a stimulation tool, a surveying tool, a telemetry tool, and/or a tough logging condition (TLC) tool, although other downhole tools are also within the scope of the present disclosure. One or more of the downhole tools 120, 130, and 150, and/or the logging and control system 160, may be utilized to perform at least a portion of one or more methods especially of different types of measurements as it is well-known from one of ordinary skill.

The downhole tools 120, 130, and/or 150 may be housed in a special type of drill collar, forming a sealed housing, as it is known in the art, and may include capabilities for measuring, processing, and/or storing information, as well as for communicating with the other downhole tools 120, 130, and/or 150, and/or directly with surface equipment, such as the logging and control system 160. Such communication may utilize various conventional and/or future-developed two-way telemetry systems, such as a mud-pulse telemetry system, a wired drill pipe telemetry system, an electromagnetic telemetry system, and/or an acoustic telemetry system, among others within the scope of the present disclosure. One or more of the downhole tools 120, 130, and/or 150 may also comprise an apparatus (not shown) for generating electrical power for use by the BHA 100. Example devices to generate electrical power include, but are not limited to, a battery system and a mud turbine generator powered by the flow of the drilling fluid.

Inside this housing, each of the tools comprise at least an electrical or electronics component, such as a sensor, an acquisition module, a telemetry module, and the like. The desiccant box according to one or more aspects of the disclosure is also stored in the housing of the drill collar.

The downhole assembly is described in drilling context but may be deployed into the wellbore via any type of conveyance means such as a wireline cable, a slickline cable, and/or coiled tubing, and at any time of the life of the well, not only drilling. It can also comprise one tool or on the contrary more tools than has been described on figure 5.

In view of the entirety of the present disclosure, a person having ordinary skill in the art should readily recognize that the present disclosure introduces a desiccant box comprising at least one wall defining an inside compartment containing a desiccant material, the box being designed so that:
- at a first temperature value, the inside compartment is a substantially vapor tight closed compartment,
- at a second temperature value superior to the first temperature value, at least one portion of the box is permeable to vapor so that the vapor can penetrate into the inside compartment.

At the second temperature value, the box may be designed so that it comprises a passage between the inside compartment and the outside of the box, this passage also allowing the passage of liquid into the compartment.

At least a portion of the box may be movable, this portion being designed so that its movement is activated in function of the temperature. This portion of the box may be made of a shape memory material or of a bimetallic element.

At least one portion of the box may be made of a material whose melting point is comprised between first and second temperature values.

At least one portion of the box may be made of a material which is substantially vapor tight at the first temperature value and permeable to water vapor at the second temperature value. In this case, the inside compartment may remain closed at the second temperature value, i.e. no liquid can penetrate into it.

The at least one portion of the box may be made of a non-porous thermoplastic film. The glass transition temperature of the thermoplastic material is set between the first and second temperature values. The thermoplastic film may be chosen among PEK (polyetherketone), PEEK (polyetheretherketone), PES (polyethersulfone), PSU (polysulfone), PPSU (polyphenylsulfone), PPF (polypropylene fumarate), PFA (polyfluoroalkoxy).

The box may be an assembly of at least two carriers defining the compartment, at least a sealingelement being interposed at the interface of the carriers.

The first temperature value may be inferior to 50°C. The second temperature value may be superior to 80°C. In some embodiments, the second temperature value is superior to 120°C.

The person skilled in the art will also be able to understand from the specification that the present disclosure introduces a downhole assembly intended to be inserted into a borehole comprising a sealed housing, wherein at least an electrical component and a desiccant box according to the disclosure are stored inside of the housing.

The person skilled in the art will also recognize that the disclosure introduces a method of operating a downhole assembly as disclosed, wherein the method comprises :
- setting the box in the housing of the downhole assembly and sealing the housing at a first temperature value so that the compartment of the box is a vapor-tight closed compartment,
- deploying the tool into a borehole of a well, the borehole temperature being a second temperature value,
- absorbing the vapor in the housing of the downhole assembly thanks to the desiccant material contained in the compartment of the desiccant box

In view of the entirety of the present disclosure, including the figures, a person skilled in the art should appreciate that they may readily use the present disclosure as a basis for designing or modifying other processes and structures for carrying out the same uses and/or achieving the same aspects introduced herein. A person skilled in the art should also realize that such equivalent constructions do not depart from the spirit and scope of the present disclosure, and that they may make various changes, substitutions and alterations herein without departing from the spirit and scope of the present disclosure. For example, although the preceding description has been described herein with reference to particular means, materials and embodiments, it is not intended to be limited to the particulars disclosed herein; rather, it extends to functionally equivalent structures, methods, and uses, such as are within the scope of the appended claims.

## Claims

1. A desiccant box comprising at least one wall defining an inside compartment containing a desiccant material, wherein the box is designed so that:
- at a first temperature value, the inside compartment is a substantially vapor tight closed compartment,
- at a second temperature value superior to the first temperature value, at least a portion of the box is permeable to vapor so that vapor can penetrate into the inside compartment.

2. The desiccant box according to the preceding claim, in which the at least one of the portions of the box is movable, this portion being designed so that its movement is activated in function of the temperature.

3. The desiccant box according to the preceding claim, in which the at least one portion of the box is made of a shape memory material.

4. The desiccant box according to claim 2, in which the at least one portion of the box is made of a bimetallic element.

5. The desiccant box according to claim 1, in which the at least one portion of the box is made of a material whose melting point is comprised between the first and second temperature value.

6. The desiccant box according to the claim 1, in which at least one portion of the box is made of a material which is substantially vapor tight at the first temperature value and permeable to water vapor at the second temperature value.

7. The desiccant box according to the preceding claim, in which the at least one portion of the box is made of a non-porous thermoplastic film whose glass-transition temperature is set between the first and second temperature value.

8. The desiccant box according to the preceding claim, in which the thermoplastic film is chosen among PEK (polyetherketone), PEEK (polyetheretherketone), PES (polyethersulfone), PSU (polysulfone), PPSU (polyphenylsulfone), PPF (polypropylene fumarate), PFA (polyfluoroalkoxy).

9. The dessicant box according to claim 1, in which the box is an assembly of at least two carriers defining the compartment, at least a sealing element being interposed at the interface of the carriers.

10. The desiccant box according to one of the preceding claims, in which the first temperature value is inferior to 50°C.

11. The desiccant box according to one of the preceding claims, in which the second temperature value is superior to 80°C.

12. A downhole assembly intended to be inserted into a borehole comprising a sealed housing, wherein at least an electrical component and the desiccant box according to any of the preceding claims are stored inside of the housing.

13. A method of operating a downhole assembly intended to be lowered in the well, comprising at least an electrical component and a desiccant box, wherein the method comprises :
- setting the box in the housing of the downhole assembly and sealing the housing at a first temperature value so that the compartment of the box is a substantially vapor-tight closed compartment,
- deploying the tool into a borehole of a well, the borehole temperature being a second temperature value,
- absorbing the vapor in the housing of the downhole assembly thanks to the desiccant material contained in the compartment of the desiccant box.
